# EUROPEAN PATENT APPLICATION

(11) **EP 4 361 755 A1**
(43) Date of publication of application: **01.05.2024**
(21) Application number: 21947163.8
(22) Date of filing: 24.06.2021
(51) Int. Cl.: G05D 23/19

(54) **INFORMATION PROCESSING DEVICE AND INFORMATION PROCESSING SYSTEM**

(71) Applicant: Sony Group Corporation, Tokyo 108-0075 (JP)
(72) Inventor: BENISE, Kimitaka, Tokyo 108-0075 (JP); OKADA, Keisuke, Tokyo 108-0075 (JP)
(74) Representative: D Young & Co LLP
(86) International application number: PCT/JP2021/024005
(87) International publication number: WO 2022/269878

(57) **Abstract**

An information processing apparatus according to an aspect of the present disclosure includes: a reception unit (13a) configured to receive temperature information from an apparatus including a temperature adjustment unit configured to adjust a temperature by cooling or heating; a storage unit (13b) configured to store log information in which pieces of the temperature information are arranged in time series; an acquisition unit (13c) configured to obtain a temperature change degree based on the log information; a generation unit (13d) configured to generate temperature control information for controlling the temperature based on the temperature change degree; and a transmission unit (13e) configured to transmit the temperature control information to the apparatus.

## Description

### Field

The present disclosure relates to an information processing apparatus and an information processing system. Background

In recent years, a cooling cooler, a cooling fan, and the like for cooling a terminal apparatus such as a smartphone have been developed in accordance with a temperature rise of the terminal apparatus. For example, the cooling cooler is equipment including a Peltier element (see, for example, Patent Literature 1). Normally, a user operates the cooling cooler or the cooling fan at an arbitrary timing to cool the terminal apparatus.

### Citation List

### Patent Literature

Patent Literature 1: JP 2010-171180 A

### Summary

### Technical Problem

However, when a cooling timing is arbitrary timing by the user, it is difficult to cool the terminal apparatus at an appropriate timing. For example, when the cooling is executed later than the appropriate timing, the temperature rise may not be stopped, and a function of the terminal apparatus may be restricted. In order to avoid this functional restriction, it is desired to appropriately adjust the temperature.

Therefore, the present disclosure proposes an information processing apparatus and an information processing system capable of appropriately adjusting the temperature.

### Solution to Problem

An information processing apparatus according to the embodiment of the present disclosure includes: a reception unit configured to receive temperature information from an apparatus including a temperature adjustment unit configured to adjust a temperature by cooling or heating; a storage unit configured to store log information in which pieces of the temperature information are arranged in time series; an acquisition unit configured to obtain a temperature change degree based on the log information; a generation unit configured to generate temperature control information for controlling the temperature based on the temperature change degree; and a transmission unit configured to transmit the temperature control information to the apparatus.

An information processing apparatus according to the embodiment of the present disclosure includes: a transmission unit configured to obtain a temperature change degree based on log information in which pieces of temperature information are arranged in time series, and transmit the temperature information to an apparatus that generates temperature control information based on the obtained temperature change degree; a reception unit configured to receive the temperature control information from the apparatus; and a control unit configured to control a temperature adjustment unit configured to adjust a temperature by cooling or heating based on the temperature control information.

An information processing system according to the embodiment of the present disclosure includes: an acquisition unit configured to obtain a temperature change degree based on log information in which pieces of temperature information are arranged in time series; a generation unit configured to generate temperature control information for controlling a temperature based on the temperature change degree; and a control unit configured to control a temperature adjustment unit configured to adjust the temperature by cooling or heating based on the temperature control information.

### Brief Description of Drawings

FIG. 1 is a diagram illustrating an example of a schematic configuration of an information processing system according to an embodiment of the present disclosure.
FIG. 2 is a diagram illustrating an example of a schematic configuration of a management server according to the embodiment of the present disclosure.
FIG. 3 is a diagram illustrating an example of a schematic configuration of a terminal apparatus according to the embodiment of the present disclosure.
FIG. 4 is a flowchart illustrating an example of a processing flow of the terminal apparatus according to the embodiment of the present disclosure.
FIG. 5 is a flowchart illustrating an example of a processing flow of the management server according to the embodiment of the present disclosure.
FIG. 6 is a diagram illustrating an example of log information according to the embodiment of the present disclosure.
FIG. 7 is a flowchart illustrating an example of a processing flow (temperature control information generation processing) of the management server according to the embodiment of the present disclosure.
FIG. 8 is a diagram illustrating an example of temperature rise according to the embodiment of the present disclosure.
FIG. 9 is a diagram for describing an operation when the terminal apparatus according to the embodiment of the present disclosure does not execute temperature control processing.
FIG. 10 is a diagram for describing an operation when the terminal apparatus according to the embodiment of the present disclosure executes temperature control processing.
FIG. 11 is a view illustrating an example of a temperature control notification image according to the embodiment of the present disclosure.
FIG. 12 is a diagram illustrating an example of a schematic configuration of hardware according to the embodiment of the present disclosure.

### Description of Embodiments

Hereinafter, embodiments of the present disclosure will be described in detail with reference to the drawings. Note that an apparatus, a system, a method, and the like according to the present disclosure are not limited by the embodiments. In each of the following embodiments, the same parts are denoted by the same reference numerals, and redundant description will be omitted.

One or a plurality of embodiments (including examples and modifications) described below can each be executed independently. On the other hand, at least some of the plurality of embodiments described below may be appropriately executed by being combined with at least some of other embodiments. The plurality of embodiments may include novel features different from each other. Therefore, the plurality of embodiments can contribute to solving different objects or problems, and can exhibit different effects.

The present disclosure will be described according to the following order of items.
1. Embodiment
   1-1. Configuration Example of Information Processing System
   1-2. Configuration Example of Management Server
   1-3. Configuration Example of Terminal Apparatus
   1-4. Processing Example of Terminal Apparatus
   1-5. Processing Example of Management Server
   1-6. Example of Temperature Control Profile Data for Specific App
   1-7. Example of Specification Expansion when There is Difference in Cooling/Heating Performance of Terminal Apparatus
   1-8. Difference in Operation Depending on Presence or Absence of Temperature Control of Terminal Apparatus
   1-9. Example of Temperature Control Notification Image
   1-10. Action and Effect
2. Other Embodiments
3. Hardware Configuration Example
4. Appendix

### <1. Embodiment>

### <1-1. Configuration Example of Information Processing System>

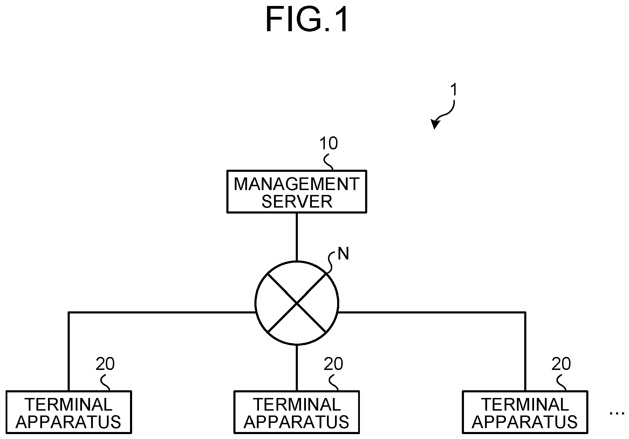

A configuration example of an information processing system 1 according to the present embodiment will be described with reference to FIG. 1. FIG. 1 is a diagram illustrating an example of a schematic configuration of the information processing system 1 according to the present embodiment. The information processing system 1 is a system for performing temperature control by managing the temperature of each terminal apparatus 20.

As illustrated in FIG. 1, the information processing system 1 includes a management server 10 and a plurality of terminal apparatuses 20. The management server 10 and the terminal apparatuses 20 are configured to be able to transmit and receive (communicate) various types of information via both or one of wireless and wired networks (communication networks) N. The management server 10 and each terminal apparatus 20 function as an information processing apparatus, respectively. Note that in the example of FIG. 1, three terminal apparatuses 20 and one network N are illustrated, but the number of terminal apparatuses 20 and the number of networks N are not limited, and one terminal apparatus 20 may be provided, and a plurality of networks N may be provided.

The network N is a communication network such as a local area network (LAN), a wide area network (WAN), a cellular network, a fixed telephone network, a regional Internet protocol (IP) network, or the Internet. The network N may include a wired network or a wireless network. In addition, the network N may include a core network. The core network is, for example, an evolved packet core (EPC) or a 5G core network (5GC). In addition, the network N may include a data network other than the core network. For example, the data network may be a service network of a telecommunications carrier, for example, an IP Multimedia Subsystem (IMS) network. Furthermore, the data network may be a private network such as an intra-company network.

For example, a communication apparatus such as the terminal apparatus 20 may be configured to be coupled to the network N by using a radio access technology (RAT) such as long term evolution (LTE), new radio (NR), Wi-Fi (registered trademark), or Bluetooth (registered trademark). At this time, the communication apparatus may be configured to be able to use different radio access technologies. For example, the communication apparatus may be configured to be able to use NR and Wi-Fi. Furthermore, the communication apparatus may be configured to be able to use different cellular communication technologies (for example, LTE and NR). LTE and NR are a type of cellular communication technology, and enable mobile communication of a communication apparatus such as the terminal apparatus 20 by disposing a plurality of areas covered by a base station in a cell shape.

The management server 10 is an information processing apparatus that manages various types of information such as temperature information or temperature control information of each terminal apparatus 20. The management server 10 may be a cloud server, a PC server, a midrange server, or a mainframe server.

The terminal apparatus 20 is a terminal (information processing apparatus) carried by the user. The terminal apparatus 20 exchanges various types of information such as temperature information or temperature control information of the terminal apparatus 20 with the management server 10. For example, the terminal apparatus 20 is a mobile phone, a smart device (smartphone or tablet), a personal digital assistant (PDA), or a personal computer.

Note that the terminal apparatus 20 may be an imaging apparatus (for example, a camcorder) having a communication function, or may be a mobile object (for example, a motorcycle or a moving relay vehicle) on which communication equipment such as a field pickup unit (FPU) is mounted. Furthermore, the terminal apparatus 20 may be an M2M (machine to machine) device or an IoT (Internet of things) device.

Furthermore, the terminal apparatus 20 may be a wearable device such as a smart watch or smart glasses. Here, the wearable device may be configured to be able to acquire information regarding the wearing user. For example, the wearable device may be configured to be able to acquire biological information of the user such as body temperature (for example, skin temperature), electro dermal activity (EDA), or pulse.

Furthermore, the terminal apparatus 20 may be an xR device such as an augmented reality (AR) device, a virtual reality (VR) device, or a mixed reality (MR) device. Here, the xR device may be a glasses-type device (for example, AR/MR/VR glasses) or a head-mounted or goggle-type device (for example, AR/MR/VR headsets or AR/MR/VR goggles). These xR devices may display a video of only one eye or may display videos of both eyes.

Furthermore, the terminal apparatus 20 may be audio equipment such as an earphone or a headphone. Note that the audio equipment may be a part of the terminal apparatus 20. For example, in a case where the audio equipment is a part of the xR device, the audio equipment may be configured such that the user can simultaneously listen to a virtual sound and a sound in a real space. Furthermore, the audio equipment may have a function (noise canceling function) of canceling a sound (environmental sound) generated in the real space.

### <1-2. Configuration Example of Management Server>

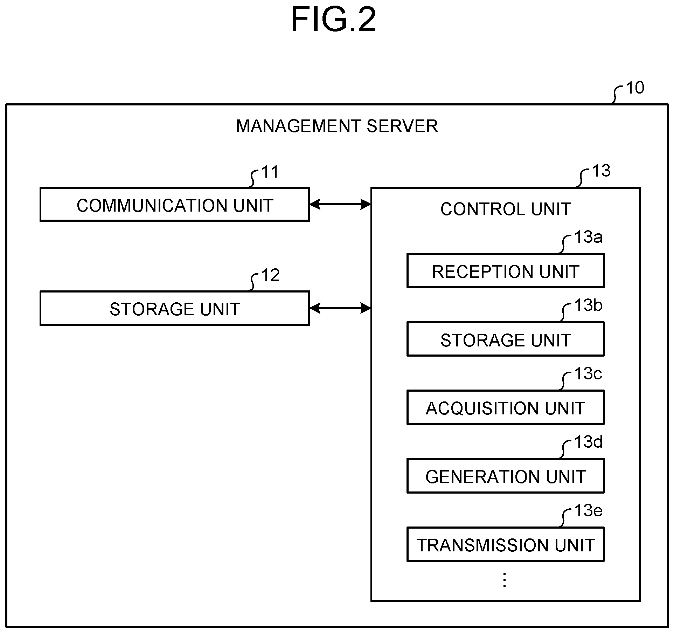

A configuration example of the management server 10 according to the present embodiment will be described with reference to FIG. 2. FIG. 2 is a diagram illustrating an example of a schematic configuration of the management server 10 according to the present embodiment.

As illustrated in FIG. 2, the management server 10 includes a communication unit 11, a storage unit 12, and a control unit 13. Note that the configuration illustrated in FIG. 2 is a functional configuration, and a hardware configuration may be different from the functional configuration. Furthermore, the functions of the management server 10 may be implemented in a distributed manner in a plurality of physically separated configurations. For example, the management server 10 may be configured by a plurality of server apparatuses.

The communication unit 11 is a communication interface for communicating with other apparatuses. For example, the communication unit 11 is a local area network (LAN) interface such as a network interface card (NIC). The communication unit 11 may be a wired interface or a wireless interface. The communication unit 11 communicates with the terminal apparatus 20 and the like under the control of the control unit 13.

The storage unit 12 is a data readable/writable storage apparatus such as a dynamic random access memory (DRAM), a static random access memory (SRAM), a flash memory, or a hard disk. The storage unit 12 stores, for example, various types of information such as temperature information or temperature control information (for example, temperature control profile data) for each terminal apparatus 20.

The control unit 13 is a controller that controls each unit of the management server 10. The control unit 13 is realized by, for example, a processor such as a central processing unit (CPU) or a micro processing unit (MPU). For example, the control unit 13 is realized by the processor executing various programs stored in the storage apparatus inside the management server 10 by using a random access memory (RAM) or the like as a work area. Note that the control unit 13 may be realized by, for example, an integrated circuit such as an application specific integrated circuit (ASIC) or a field programmable gate array (FPGA). Any of the CPU, the MPU, the ASIC, and the FPGA can be regarded as a controller. Note that the control unit 13 may be realized by a GPU in addition to or instead of the CPU.

The control unit 13 includes a reception unit 13a, a storage unit 13b, an acquisition unit 13c, a generation unit 13d, and a transmission unit 13e. Each block (reception unit 13a to transmission unit 13e) constituting the control unit 13 is a functional block indicating a function of the control unit 13. These functional blocks may be software blocks or hardware blocks. For example, each of the functional blocks described above may be one software module realized by software (including a microprogram), or may be one circuit block on a semiconductor chip (die). Of course, each functional block may be one processor or one integrated circuit. The control unit 13 may be configured by a functional unit different from the above-described functional block. A configuration method of the functional block is arbitrary.

Note that the control unit 13 may be configured by a functional unit different from the above-described functional block. In addition, some or all of the operations of the blocks (the reception unit 13a to the transmission unit 13e) constituting the control unit 13 may be performed by other apparatuses. The operation of each block constituting the control unit 13 will be described later.

### <1-3. Configuration Example of Terminal Apparatus>

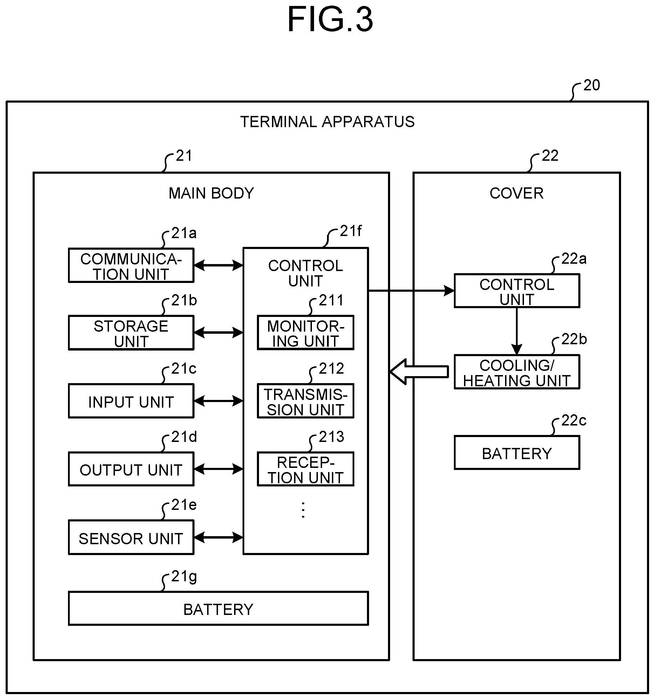

A configuration example of the terminal apparatus 20 according to the present embodiment will be described with reference to FIG. 3. FIG. 3 is a diagram illustrating an example of a schematic configuration of the terminal apparatus 20 according to the present embodiment.

As illustrated in FIG. 3, the terminal apparatus 20 includes a main body 21 and a cover 22. The main body 21 includes a communication unit 21a, a storage unit 21b, an input unit 21c, an output unit 21d, a sensor unit 21e, a control unit 21f, and a battery 21g. The cover 22 includes a control unit 22a, a cooling/heating unit 22b, and a battery 22c. The cover 22 has, for example, a shape that covers the main body 21 and is formed to be attachable to and detachable from the main body 21. Note that the configuration illustrated in FIG. 3 is a functional configuration, and the hardware configuration may be different from this. For example, the cover 22 may be omitted, and the cooling/heating unit 22b may be provided in the main body 21. Furthermore, the functions of the terminal apparatus 20 may be implemented in a distributed manner in a plurality of physically separated configurations.

The communication unit 21a is a communication interface for communicating with other apparatuses. For example, the communication unit 21a is a LAN interface such as an NIC. Note that the communication unit 21a may be a wired interface or a wireless interface. The communication unit 21a communicates with the management server 10 and the like under the control of the control unit 21f.

The storage unit 21b is a storage apparatus capable of reading and writing data, such as a DRAM, an SRAM, a flash memory, or a hard disk.

The input unit 21c is an input apparatus that receives various inputs from an outside. For example, the input unit 21c is an operation apparatus for the user to perform various operations, such as a keyboard, a mouse, or operation keys. Note that in a case where a touch panel is adopted as the terminal apparatus 20, the touch panel is also included in the input unit 21c. In this case, the user performs various operations by touching a screen with a finger or a stylus. Furthermore, the input unit 21c may be a voice input apparatus (for example, a microphone) that receives an input operation by an operator's voice.

The output unit 21d is an apparatus that performs various outputs such as sound, light, vibration, or an image to the outside. The output unit 21d includes a display apparatus that displays various types of information. The display apparatus is, for example, a liquid crystal display or an organic electro luminescence (EL) display. Note that in a case where a touch panel is adopted as the terminal apparatus 20, the display apparatus may be an apparatus integrated with the input unit 21c. The output unit 21d performs various outputs to the user under the control of the control unit 21f.

The sensor unit 21e is a sensor that acquires temperature information of the main body 21 and acquires environmental information or biological information. The temperature information of the main body 21 may be, for example, temperature information around the battery 21g or temperature information of the battery 21g itself. For example, the sensor unit 26 may be a temperature sensor such as a thermometer, an environmental sensor such as a thermometer, a hygrometer, or a CO₂ concentration meter, or a biological sensor such as a thermometer, a pulsometer, or an electro dermal activity meter. The environmental information is, for example, temperature, humidity, CO₂ concentration, and the like, and the biological information is, for example, body temperature, pulse, electro dermal activity, and the like.

The control unit 21f is a controller that controls each unit of the main body 21. The control unit 21f is realized by, for example, a processor such as a CPU or an MPU. For example, the control unit 21f is realized by a processor executing various programs stored in a storage apparatus inside the terminal apparatus 20 by using a RAM or the like as a work area. Note that the control unit 21f may be realized by an integrated circuit such as an ASIC or an FPGA. Any of the CPU, the MPU, the ASIC, and the FPGA can be regarded as a controller. Furthermore, the control unit 21f may be realized by a GPU in addition to or instead of the CPU.

The control unit 21f includes a monitoring unit 211, a transmission unit 212, and a reception unit 213. Each block (the monitoring unit 211 to the reception unit 213) constituting the control unit 13 is a functional block indicating a function of the control unit 21f, respectively. These functional blocks may be software blocks or hardware blocks. For example, each of the functional blocks described above may be one software module realized by software (including a microprogram), or may be one circuit block on a semiconductor chip (die). Of course, each functional block may be one processor or one integrated circuit. The control unit 21f may be configured by a functional unit different from the above-described functional block. A configuration method of the functional block is arbitrary.

Note that the control unit 21f may be configured by a functional unit different from the above-described functional block. In addition, some or all of the operations of the blocks (the monitoring unit 211 to the reception unit 213) constituting the control unit 21f may be performed by other apparatuses. The operation of each block constituting the control unit 21f will be described later.

The battery 21g supplies power to each unit of the main body 21. The battery 21g may be, for example, a dry battery or a secondary battery (battery). For example, in a power-on state of the terminal apparatus 20, the battery 21g continuously supplies power to any of the units of the main body 21.

The control unit 22a is a controller that controls each unit of the cover 22, mainly the cooling/heating unit 22b, according to the control of the control unit 21f of the main body 21. The control unit 22a is realized by, for example, a processor such as a CPU or an MPU. For example, the control unit 22a is realized by a processor executing various programs stored in a storage apparatus inside the terminal apparatus 20 by using a RAM or the like as a work area. Note that the control unit 22a may be realized by an integrated circuit such as an ASIC or an FPGA. Any of the CPU, the MPU, the ASIC, and the FPGA can be regarded as a controller. Furthermore, the control unit 22a may be realized by a GPU in addition to or instead of the CPU.

The cooling/heating unit 22b cools or heats the main body 21 of the terminal apparatus 20. The cooling/heating unit 22b executes cooling or heating under the control of the control unit 22a. Note that in a case where it is not necessary to perform both cooling and heating, an apparatus that performs either cooling or heating, for example, a cooling unit or a heating unit may be provided instead of the cooling/heating unit 22b. The cooling/heating unit 22b, the cooling unit, or the heating unit corresponds to a temperature adjustment unit.

For example, in the main body 21, the control unit 22a functioning as the battery 21g at the time of charging and a charging system unit at the time of charging, the output unit 21d functioning as a camera module unit at the time of camera photographing, the control unit 22a at the time of game, and the like become hot, and thus, these units are directly or indirectly cooled by the cooling/heating unit 22b. In addition, when the battery 21g during a normal operation is excessively cooled, the battery 21g cannot be used, so that the battery 21g is directly or indirectly heated by the cooling/heating unit 22b.

The battery 22c supplies power to each unit of the cover 22, for example, the control unit 22a and the cooling/heating unit 22b. The battery 22c may be, for example, a dry battery or a secondary battery (battery). For example, the battery 22c has a capacity smaller than that of the battery 21g of the main body 21.

### <1-4. Processing Example of Terminal Apparatus>

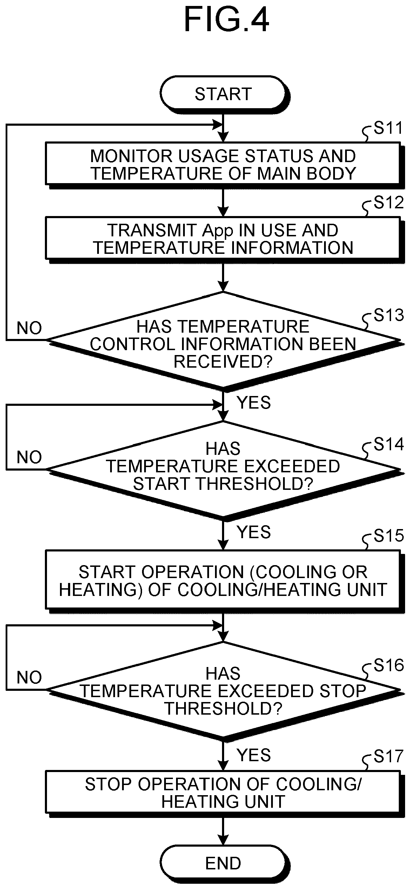

A processing example of the terminal apparatus 20 according to the present embodiment will be described with reference to FIG. 4. FIG. 4 is a flowchart illustrating an example of a processing flow of the terminal apparatus 20 according to the present embodiment.

As illustrated in FIG. 4, in step S11, a usage status (use case) and the temperature (the temperature of the main body 21) of the main body 21 are monitored by the monitoring unit 211. In step S12, the transmission unit 212 transmits an App in use and temperature information (for example, information on an application name and a main body temperature) to the management server 10. The transmission unit 212 transmits the App in use and the temperature information to the communication unit 21a, and transmits the App in use and the temperature information to the management server 10 via the network N.

In step S13, the reception unit 213 determines whether temperature control information (profile data) has been received. The reception unit 213 receives the temperature control information from the management server 10 via the network N through the communication unit 21a, and receives the temperature control information from the communication unit 21a. Note that the temperature control information is generated by the management server 10 and transmitted to the terminal apparatus 20. The generation of the temperature control information will be described later in detail.

When it is determined in step S13 that the temperature control information has not been received (No in step S13), the processing returns to step S11. On the other hand, when it is determined that the temperature control information has been received (Yes in step S13), in step S14, the control unit 22a determines whether the temperature (the temperature of the main body 21) has exceeded a start threshold based on the temperature control information. Specifically, for example, the control unit 22a performs control according to the control of the control unit 21f based on the temperature control information. Note that the temperature control information may be stored in the storage unit 21b.

When it is determined in step S14 that the temperature has not exceeded the start threshold (No in step S14), the processing returns to step S14. On the other hand, when it is determined that the temperature has exceeded the start threshold (Yes in step S14), in step S15, the operation (cooling or heating) of the cooling/heating unit 22b is started by the control unit 22a.

In step S16, the control unit 22a determines whether the temperature (the temperature of the main body 21) has exceeded a stop threshold based on the temperature control information. When it is determined that the temperature has not exceeded the stop threshold (No in step S16), the processing returns to step S16. On the other hand, when it is determined that the temperature has exceeded the stop threshold (Yes in step S16), in step S17, the operation (cooling or heating) of the cooling/heating unit 22b is stopped by the control unit 22a.

### <1-5. Processing Example of Management Server>

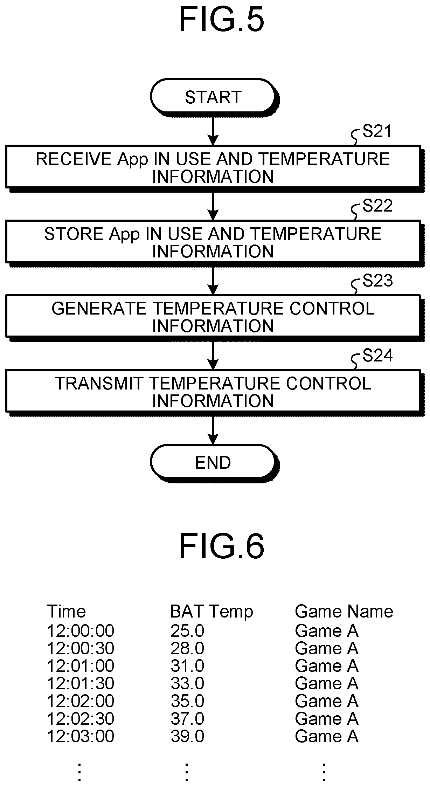

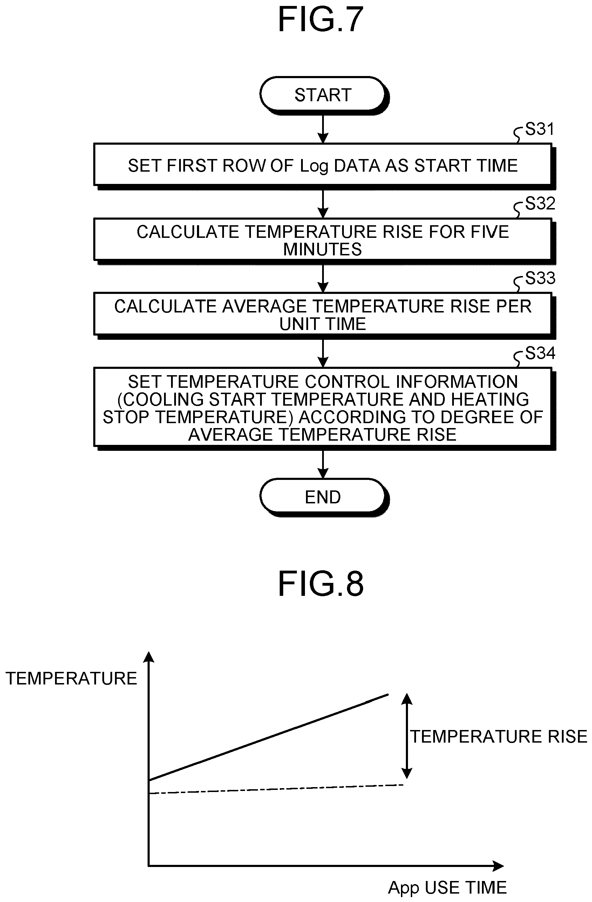

A processing example of the management server 10 according to the present embodiment will be described with reference to FIGS. 5 to 8. FIG. 5 is a flowchart illustrating an example of a processing flow of the management server 10 according to the present embodiment. FIG. 6 is a diagram illustrating an example of log information according to the present embodiment. FIG. 7 is a flowchart illustrating an example of a processing flow (temperature control information generation processing) of the management server 10 according to the present embodiment. FIG. 8 is a diagram illustrating an example of a temperature rise according to the present embodiment.

As illustrated in FIG. 5, in step S21, the App in use and the temperature information (for example, information on the application name and the main body temperature) are received by the reception unit 13a, and in step S22, the received App in use and temperature information are stored by the storage unit 13b. The reception unit 13a receives the App in use and the temperature information from the terminal apparatus 20 via the network N through the communication unit 11, and receives the App in use and the temperature information from the communication unit 11. Furthermore, the storage unit 13b stores the App in use and the temperature information in time series in the storage unit 12.

Next, in step S23, temperature control information (profile data) is generated by the generation unit 13d, and in step S24, the generated temperature control information is transmitted to the terminal apparatus 20 by the transmission unit 13e. The transmission unit 13e transmits the temperature control information to the communication unit 11 and transmits the temperature control information to the terminal apparatus 20 via the network N. Note that the acquisition unit 13c obtains a temperature change degree (for example, a temperature rise rate or a temperature drop rate) from the stored App in use and the temperature information, and the generation unit 13d generates the temperature control information from the temperature change degree.

In step S22, for example, as illustrated in FIG. 6, log information indicating the App in use and the temperature information is periodically stored in the storage unit 12. In the example of FIG. 6, as an example of the log information, a temperature (BAT Temp) of the battery 21g as the temperature of the main body 21 and a game name (Game Name) which is an App being operated are associated with each other for each measurement time (Time) and stored in the storage unit 12. The log information is information in which the temperature of the battery 21g of the main body 21 and the game name being operated are arranged in time series. Since the log information also includes the game name being operated (App being operated), the log information also functions as data related to consumption of the battery 21g of the main body 21. Note that in a case where there is a plurality of terminal apparatuses 20, in addition to the temperature of the battery 21g of the main body 21 and the game name being operated, a type or identification information (for example, a model number, ID, and the like of a product) of the terminal apparatus 20 may be stored in association. As a result, the log information can be managed for each terminal apparatus 20.

Here, in a case where a plurality of Apps are operated (activated) by multiple windows, it is difficult to determine which App caused the temperature rise, and thus, it is not necessary to leave the log information (log data). On the other hand, even when a plurality of Apps are being operated, the log information may be left. For example, when a plurality of Apps being operated are different games, the temperature of the battery 21g of the main body 21 and a plurality of game names being operated (for example, Game A + Game B) are associated and stored in the storage unit 12.

In step S23, the temperature control information is generated by the generation unit 13d. Specifically, as illustrated in FIG. 7, in step S31, a first row of log data (Log data) is set as a start time, and in step S32, a temperature rise (temperature rise value) for five minutes is calculated by the acquisition unit 13c. In step S33, an average temperature rise per unit time (average temperature rise value) is calculated by the acquisition unit 13c from the temperature rise for the five minutes. For example, when a plurality of Apps are being activated, an average temperature rise for each App is calculated. In step S24, the temperature control information (a cooling start temperature and a heating stop temperature) is set by the generation unit 13d according to a degree of the average temperature rise (an example of the temperature change degree). As a result, the temperature control information is generated.

In step S33 described above, for example, the cooling start temperature and the heating stop temperature are changed by the generation unit 13d depending on which of a first threshold, a second threshold, and a third threshold (for example, each threshold specified by a constant) the average temperature rise exceeds. The first threshold, the second threshold, and the third threshold have a relationship of first threshold > second threshold > third threshold. As an example, when the average temperature rise exceeds the first threshold, the cooling start temperature is 20°C and the heating stop temperature is 1°C. When the average temperature rise exceeds the second threshold, the cooling start temperature is 22°C and the heating stop temperature is 2°C. When the average temperature rise exceeds the third threshold, the cooling start temperature is 24°C and the heating stop temperature is 3°C. In this manner, the temperature rise rates are grouped by thresholds, and the cooling start temperature and the heating stop temperature of each group are set. For example, the cooling start temperature is set lower as the temperature rise rate is higher.

In such processing, as illustrated in FIG. 8, the management server 10 obtains a temperature change degree (for example, the temperature rise rate) of the battery 21g from the temperature rise of the battery 21g of the main body 21 (temperature rise according to the App use time), and generates temperature control information for operating the cooling/heating unit 22b at an appropriate timing according to the obtained temperature change degree. Note that a procedure of obtaining the temperature change degree (for example, the temperature drop rate) from the temperature drop is also similar to a procedure of obtaining the temperature change degree (for example, the temperature rise rate) from the temperature rise described above.

Specifically, the terminal apparatus 20 monitors the operating App and the temperature of the main body 21 in a short cycle, leaves the same in log information (log data), and updates the log information to the management server 10 periodically or in real time. The management server 10 analyzes the log information updated by each terminal apparatus 20, calculates the temperature rise of the main body 21 per hour for each App, and for example, determines an App of which a temperature rise rate is the highest or higher than a predetermined value. Then, the management server 10 creates, for each terminal apparatus 20, a temperature control profile corresponding to the App of which the temperature rise rate is the highest or higher than the predetermined value, and distributes temperature control profile data (an example of the temperature control information) to the terminal apparatus 20. The temperature rise rate is an example of a contribution degree by which an App contributes to a temperature change of the main body 21.

The terminal apparatus 20 downloads the temperature control profile data for a specific App from the management server 10. When detecting activation of the specific App, the terminal apparatus 20 instructs the cooling/heating unit 22b to perform cooling or heating based on the downloaded temperature control profile data. Note that in a case where the specific App is not activated, for example, cooling and heating are controlled by a threshold of the temperature of the main body 21. For example, when the temperature of the main body 21 is lower than a predetermined threshold (for example, 5°C), heating is instructed to the cooling/heating unit 22b, and when the temperature of the main body 21 is higher than a predetermined threshold (for example, 35°C), cooling is instructed.

### <1-6. Example of Temperature Control Profile Data for Specific App>

An example of temperature control profile data (profile data) for a specific App according to the present embodiment will be described.

A data format of the profile data includes, for example,
[App name]: Create a profile section for each application name
ColdStartDegree = X: cooling start temperature X°C
WarmStopDegree = Y: heating stop temperature Y°C. Note that in a case where there is a temperature control profile for a plurality of Apps, the section is added. The temperature control profile is described, for example, in a text format.

Specifically, as the profile data, for example, profile data such as
[Camera A]
   ColdStartDegree = 20
   WarmStopDegree = 1
[Game A]
   ColdStartDegree = 22
   WarmStopDegree = 2
   is created.

The profile data of Camera A (camera A) is data for performing cooling at a BAT temperature of 20°C or higher and heating at a BAT temperature of 1°C or lower when an application of Camera A is activated. The profile data of Game A (game A) is data for performing cooling at a BAT temperature of 22°C or higher and heating at a BAT temperature of 2°C or lower when an application of Game A is activated. Therefore, the control unit 22a in the cover 22 of the terminal apparatus 20 controls the cooling/heating unit 22b (for example, on/off of cooling and heating) based on the profile data as described above.

In the above example, since the camera application has a higher temperature rise rate than the game application, the camera application is set to start cooling at 20°C lower than the game application. Similarly for heating, the camera application has a higher temperature rise rate than the game application. Therefore, in the camera application, heating is started when the temperature is equal to or lower than a predetermined temperature, and heating is stopped when the temperature becomes 1°C that is lower than the temperature of the game application.

### <1-7. Example of Specification Expansion when There is Difference in Cooling/Heating Performance of Terminal Apparatus>

An example of specification extension in a case where there is a plurality of models (for example, a high-grade model, an inexpensive model, or the like) in the cover 22 of the terminal apparatus according to the present embodiment and there is a difference in heating/cooling performance will be described.

There are a plurality of models of the cover 22, and there is a difference in cooling/heating performance between the covers 22. Each cover 22 has its own model number data, and the control unit 22a on the cover 22 side can notify the control unit 21f on the main body 21 side of the stored model number data. As extension of a profile data format, a portion of [App name] is extended to [App name, cover model number], and a profile for each model (for example, model number data) of the cover 22 can be created.

For example, when Model B (model B) has lower heating/cooling performance than Cover Model A (model A), a profile such as
[Game A, Cover Model A]
   ColdStartDegree = 22
   WarmStopDegree = 2
[Game A, Cover Model B]
   ColdStartDegree = 20
   WarmStopDegree = 4
   is created.

### <1-8. Difference in Operation Depending on Presence or Absence of Temperature Control of Terminal Apparatus>

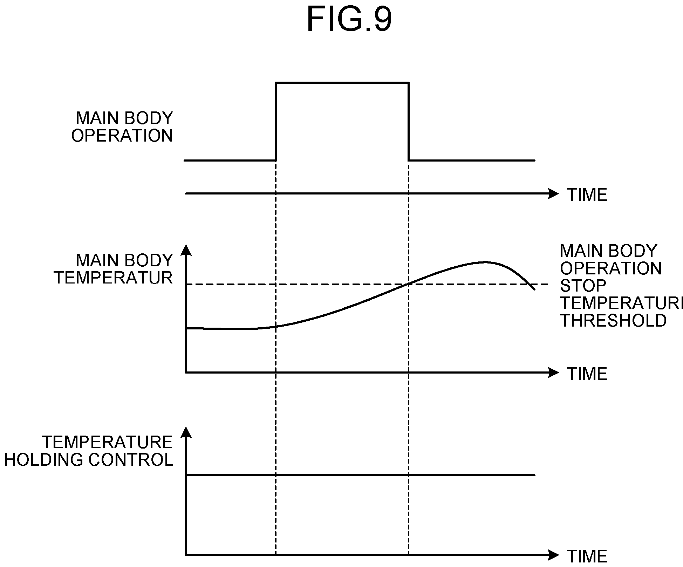

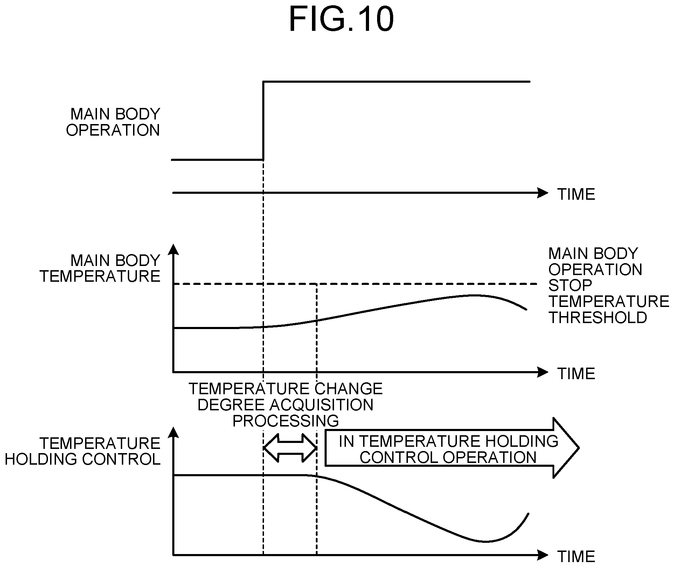

The difference in the operation depending on the presence or absence of temperature control (temperature holding control) of the terminal apparatus 20 according to the present embodiment will be described with reference to FIGS. 9 and 10. FIG. 9 is a diagram for describing an operation in a case where the terminal apparatus 20 does not execute temperature control processing. FIG. 10 is a diagram for describing an operation in a case where the terminal apparatus 20 executes temperature control processing.

As illustrated in FIG. 9, in a case where the terminal apparatus 20 does not execute the temperature control processing (in a case where the graph of the temperature holding control in FIG. 9 is constant), when the temperature of the main body 21 (main body temperature) exceeds a main body operation stop temperature threshold, the operation of the main body 21 (main body operation) is stopped. Specifically, the terminal apparatus 20 determines whether the main body temperature has exceeded the main body operation stop temperature threshold, and stops a predetermined main body operation (for example, operation with high battery consumption) when it is determined that the main body temperature exceeds the main body operation stop temperature threshold. As described above, when the temperature control processing is not executed, an operation restriction (temperature protection) is applied.

As illustrated in FIG. 10, in a case where the terminal apparatus 20 executes the temperature control processing (in a case where the graph of the temperature holding control in FIG. 10 changes), temperature change degree acquisition processing (for example, a temperature rise rate or a temperature drop rate acquisition processing) is executed, and the temperature holding control is performed based on the temperature control information according to the temperature change degree which is the acquisition result. Specifically, the management server 10 obtains a temperature change degree (for example, a temperature rise rate or a temperature drop rate) of the main body 21, generates temperature control information based on the obtained temperature change of the main body 21, and transmits the temperature control information to the terminal apparatus 20. The terminal apparatus 20 executes the temperature holding control based on the received temperature control information. As a result, the temperature of the main body 21 (main body temperature) is suppressed from exceeding the main body operation stop temperature threshold, and the operation of the main body 21 (main body operation) is continued without being stopped. Note that in the example of FIG. 10, the fact that the graph related to the temperature holding control decreases with the lapse of time indicates that the cooling operation of the cooling/heating unit 22b starts and the cooling temperature decreases.

In such temperature control processing, the management server 10 obtains in advance the temperature change degree related to the temperature change up to the operation restriction (temperature protection) in a low temperature or high temperature environment, and the terminal apparatus 20 can continue the function of the main body 21 without restricting the operation by heating or cooling the main body 21 by the cooling/heating unit 22b based on the temperature control information according to the temperature change degree of the management server 10. Specifically, in order to obtain the temperature change degree from a use case, the terminal apparatus 20 adds the temperature information of the terminal apparatus 20 to App log used (log information of App) and transmits the temperature information to the management server 10. The management server 10 manages the log information of the App including the temperature information of the terminal apparatus 20. Then, the management server 10 reads log information of an appropriate App according to the use case, obtains a temperature change degree of the terminal apparatus 20 used by the user, generates temperature control information for operating the cooling/heating unit 22b at an appropriate timing according to the obtained temperature change degree, and transmits the temperature control information to the terminal apparatus 20. The terminal apparatus 20 performs temperature control processing based on the temperature control information. As a result, the functional restriction of the terminal apparatus 20 can be suppressed.

Therefore, the user can use the function without impairing the function due to the functional restriction. In addition, since the cooling/heating unit 22b of the cover 22 operates only when necessary as compared with a conventional external accessory or the like, a system operation time becomes longer than that of the conventional product. In addition, since the temperature rise up to the main body operation stop temperature threshold (functional restriction temperature threshold) can be predicted from the temperature change degree, it is also possible to notify the user of the function stop in advance. In addition, since the temperature control profile data is managed by the management server 10, the latest data can be used for the terminal apparatuses 20 of all the users. For example, when the management server 10 transmits the temperature control profile data corresponding to the specific App to another terminal apparatus 20 on which the specific App is activated, the another terminal apparatus 20 can use the temperature control profile data corresponding to the specific App.

### <1-9. Example of Temperature Control Notification Image>

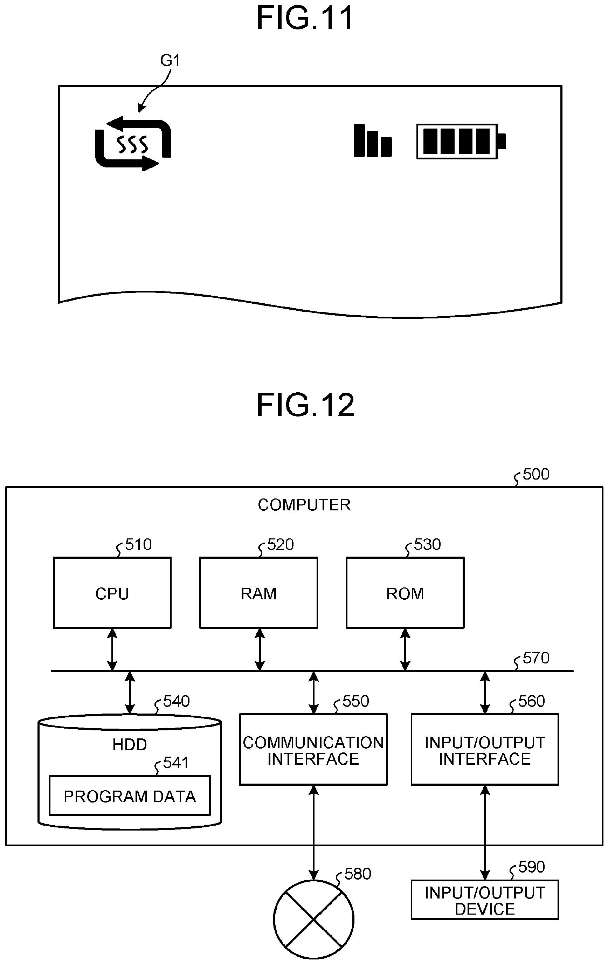

An example of a temperature control notification image according to the present embodiment will be described. FIG. 11 is a diagram illustrating an example of the temperature control notification image according to the present embodiment.

As illustrated in FIG. 11, a temperature control notification image G1 is an image indicating that temperature control (temperature holding control) is executed. In the example of FIG. 11, the temperature control notification image G1 is displayed on an upper left of the display apparatus (display unit) of the terminal apparatus 20. A display position of the temperature control notification image G1 is not limited. For example, an image such as a figure such as a picture is used as the temperature control notification image G1, but characters such as a message may be displayed in addition to the temperature control notification image G1.

For example, when executing temperature control (temperature holding control), the control unit 21f of the terminal apparatus 20 reads the temperature control notification image G1 stored in the storage unit 21b, and causes the display apparatus as the output unit 21d to display the temperature control notification image G1. On the other hand, when the temperature control is not executed, the temperature control notification image G1 is not displayed. In this manner, the temperature control notification image G1 is displayed according to whether the temperature control processing is executed.

Note that an image for selecting temperature control for temperature holding may be displayed by a pop-up or the like. In addition, the main body 21 may display a remaining prediction time that the main body 21 can operate without functional restriction. The remaining operable prediction time is obtained by the control unit 21f of the terminal apparatus 20 or the acquisition unit 13c of the management server 10 from the temperature change degree of the main body 21, for example. For example, the control unit 21f or the acquisition unit 13c predicts how long it will take for the temperature of the main body 21 to rise up to the main body operation stop temperature threshold from the current time based on the temperature change degree (for example, the temperature rise rate or the temperature drop rate) of the main body 21, and can obtain an operable prediction time. At this time, necessary information is transmitted and received between the management server 10 and the terminal apparatus 20.

### <1-10. Action and Effect>

As described above, according to the present embodiment, the management server 10 (an example of the information processing apparatus) includes the reception unit 13a that receives temperature information from the terminal apparatus 20 (an example of the information processing apparatus) including the cooling/heating unit 22b (an example of the temperature adjustment unit) that adjusts a temperature by cooling or heating, the storage unit 13b that stores log information in which pieces of temperature information are arranged in time series, the acquisition unit 13c that obtains a temperature change degree based on the log information, the generation unit 13d that generates temperature control information for controlling a temperature based on the temperature change degree (for example, the temperature rise rate or the temperature drop rate), and the transmission unit 13e that transmits the temperature control information to the terminal apparatus 20. As a result, the terminal apparatus 20 can control the cooling/heating unit 22b based on the temperature control information according to the temperature change degree, so that the temperature can be appropriately adjusted.

Further, the reception unit 13a may receive software information indicating software being activated of the terminal apparatus 20 and temperature information of the terminal apparatus 20, the storage unit 13b may store log information in which the software information and the temperature information of the terminal apparatus 20 are arranged in time series, and the acquisition unit 13c may obtain a temperature change degree of the terminal apparatus 20 based on the log information. As a result, the terminal apparatus 20 can control the cooling/heating unit 22b based on the temperature control information according to the temperature change degree in consideration of the software being activated (temperature rise due to the software being activated), so that the temperature can be more appropriately adjusted.

In addition, the acquisition unit 13c may obtain the temperature rise rate or the temperature drop rate of the terminal apparatus 20 as the temperature change degree of the terminal apparatus 20 based on the log information. As a result, the temperature change degree of the terminal apparatus 20 can be reliably and accurately obtained.

Furthermore, in a case where a plurality of pieces of software are being activated in the terminal apparatus 20, the reception unit 13a may receive software information indicating the plurality of pieces of software being activated and temperature information of the terminal apparatus 20. As a result, the terminal apparatus 20 can control the cooling/heating unit 22b based on the temperature control information according to the temperature change degree of the terminal apparatus 20 in consideration of the plurality of pieces of software being activated (temperature rise by the plurality of pieces of software being activated), so that the temperature can be more appropriately adjusted.

In addition, the acquisition unit 13c may obtain the temperature rise rate or the temperature drop rate of the terminal apparatus 20 corresponding to the combination of the plurality of pieces of software being activated as the temperature change degree of the terminal apparatus 20 based on the log information. As a result, the temperature change degree of the terminal apparatus 20 can be reliably and accurately obtained. For example, a value obtained by adding the temperature rise rate of each software is set as the temperature rise rate in a case where a plurality of pieces of software are being activated.

In addition, the acquisition unit 13c may select the plurality of pieces of software information and the temperature information of the plurality of terminal apparatuses 20 to be used from the log information, and obtain the temperature change degree of the terminal apparatus 20 based on the selected plurality of pieces of software information and the temperature information of the plurality of terminal apparatuses 20. As a result, the temperature change degree of the terminal apparatus 20 can be reliably and accurately obtained.

In addition, the acquisition unit 13c may select the plurality of pieces of software information and the temperature information of the plurality of terminal apparatuses 20 to be used from the log information according to the contribution degree by which the software contributes to the temperature change of the terminal apparatus 20. As a result, the temperature change degree of the terminal apparatus 20 can be obtained more reliably and accurately.

In addition, the acquisition unit 13c may obtain software of which a contribution degree is the highest or higher than a predetermined value based on the log information, and select the software information corresponding to the obtained software and the temperature information of the terminal apparatus 20. As a result, the temperature change degree of the terminal apparatus 20 can be obtained more reliably and accurately.

Furthermore, the reception unit 13a may periodically receive the software information and the temperature information of the terminal apparatus 20 from the terminal apparatus 20. As a result, the temperature change degree of the terminal apparatus 20 can be reliably and accurately obtained.

Furthermore, the reception unit 13a may collectively and periodically receive the plurality of pieces of software information and the temperature information of the plurality of terminal apparatuses 20 from the terminal apparatus 20. As a result, the temperature change degree of the terminal apparatus 20 can be reliably and accurately obtained.

In addition, the log information may be data related to the battery consumption of the terminal apparatus 20. As a result, the temperature change degree of the terminal apparatus 20 can be reliably and accurately obtained.

Furthermore, the temperature information of the terminal apparatus 20 may be battery temperature information of the terminal apparatus 20. As a result, the temperature change degree of the terminal apparatus 20 can be reliably and accurately obtained.

Furthermore, the temperature control information may be information for suppressing the temperature change of the terminal apparatus 20. As a result, the temperature change of the terminal apparatus 20 can be reliably suppressed.

Furthermore, the transmission unit 13e may transmit the temperature control information to another apparatus other than the terminal apparatus 20. As a result, since the temperature can be adjusted based on the temperature control information even in the another apparatus, the temperature control information can also be applied to the another apparatus.

In addition, the terminal apparatus 20 includes a transmission unit 212 that obtains a temperature change degree based on log information in which pieces of temperature information are arranged in time series and transmits temperature information to the management server 10 that generates temperature control information based on the obtained temperature change degree, a reception unit 213 that receives the temperature control information from the management server 10, and a control unit 22a that controls the cooling/heating unit 22b that adjusts the temperature by cooling or heating based on the temperature control information. As a result, the terminal apparatus 20 can control the cooling/heating unit 22b based on the temperature control information according to the temperature change degree, so that the temperature can be appropriately adjusted.

In addition, the transmission unit 212 may transmit software information indicating software being activated of the terminal apparatus 20 and temperature information of the terminal apparatus 20. As a result, the terminal apparatus 20 can control the cooling/heating unit 22b based on the temperature control information according to the temperature change degree in consideration of the software being activated (temperature rise due to the software being activated), so that the temperature can be more appropriately adjusted.

In addition, in a case where a plurality of pieces of software are being activated in the terminal apparatus 20, the transmission unit 212 may transmit software information indicating the plurality of pieces of software being activated and temperature information of the terminal apparatus 20. As a result, the terminal apparatus 20 can control the cooling/heating unit 22b based on the temperature control information according to the temperature change degree in consideration of the plurality of pieces of software being activated (temperature rise by the plurality of pieces of software being activated), so that the temperature can be more appropriately adjusted.

Furthermore, the terminal apparatus 20 may include a display unit (an example of the output unit 21d) that displays an image (for example, a figure or the like) or characters (for example, a message or the like) indicating that the control unit 22a controls the cooling/heating unit 22b. As a result, the user who uses the terminal apparatus 20 can visually recognize the image or the characters indicating that the control unit 22a controls the cooling/heating unit 22b and can grasp that the control unit 22a controls the cooling/heating unit 22b.

Furthermore, the terminal apparatus 20 may include a display unit (an example of the output unit 21d) that displays a remaining operable prediction time of the terminal apparatus 20 (itself). As a result, the user who uses the terminal apparatus 20 can visually recognize the remaining operable prediction time of the terminal apparatus 20 and grasp the remaining operable prediction time of the terminal apparatus 20.

### <2. Other Embodiments>

The processing according to the embodiment (modification) described above may be executed in various different forms (modification) other than the embodiment described above. For example, among each of the processing described in the above embodiment, all or a part of the processing described as being automatically performed can be manually performed, or all or a part of the processing described as being manually performed can be automatically performed by a known method. In addition, the processing procedure, specific name, and information including various types of data and parameters indicated in the specification and the drawings above can be arbitrarily changed unless otherwise specified. For example, the various types of information indicated in each drawing are not limited to the illustrated information.

In addition, each component of each apparatus illustrated in the drawings is functionally conceptual, and is not necessarily physically configured as illustrated in the drawings. That is, a specific form of distribution and integration of each apparatus is not limited to the illustrated form, and all or a part thereof can be functionally or physically distributed and integrated in an arbitrary unit according to various loads, usage status, and the like.

In addition, the above-described embodiment (or modification) can be appropriately combined within a range that does not contradict processing contents. Furthermore, the effects described in the present specification are merely examples and are not limited, and other effects may be provided.

Furthermore, for example, as the information processing apparatus, a vehicle having a communication function may be coupled to the management server 10 via the network N instead of the terminal apparatus 20. In this case, the vehicle includes an air conditioner (air conditioner) and the like, and the management server 10 generates temperature control information for controlling an in-vehicle temperature based on data such as in-vehicle temperature data. For example, the vehicle periodically transmits in-vehicle temperature information to the management server 10 via the network N.

Furthermore, instead of the terminal apparatus 20 as the information processing apparatus, a house such as a smart house or a garden house may be coupled to the management server 10 via the network N. In this case, the house includes an air conditioner (air conditioner), an air cooler, a heater, or the like, and the management server 10 generates temperature control information for controlling a room temperature based on data such as weather data or temperature data in the house. For example, the house transmits temperature information in the house to the management server 10 via the network N. Note that weather data is also information related to the temperature.

Instead of the terminal apparatus 20 as the information processing apparatus, a refrigerator having a communication function may be coupled to the management server 10 via the network N. In this case, the management server 10 generates temperature control information for controlling the temperature inside the refrigerator based on data such as food data or temperature data inside the refrigerator. For example, the refrigerator periodically transmits temperature information of the refrigerator (as an example, temperature information for each refrigerator) to the management server 10 via the network N.

Furthermore, instead of the terminal apparatus 20 as the information processing apparatus, a cup that can be cooled or heated may be coupled to the management server 10 via the network N. In this case, for example, the cup has a Peltier element, a battery, a wireless communication device, and the like, and the management server 10 generates temperature control information for controlling the temperature of the cup based on data such as temperature data of the cup. For example, the cup periodically transmits temperature information of the cup to the management server 10 via the network N. Here, for example, when the user selects a type of drink with an application on equipment such as a smartphone, the cup acquires temperature control information appropriate for the drink from the management server 10, and keeps the drink in the cup at an appropriate temperature. For example, according to the temperature control information, the cup keeps 5°C when the drink is beer, and keeps 15°C when the drink is wine.

### <3. Hardware Configuration Example>

A specific hardware configuration example of information equipment such as the management server 10 or the terminal apparatus 20 according to the above-described embodiment (or modification) will be described. The information equipment such as the management server 10 or the terminal apparatus 20 according to the embodiment (or the modification) may be realized by, for example, a computer 500 having a configuration as illustrated in FIG. 12. FIG. 12 is a diagram illustrating a configuration example of hardware that realizes functions of the information equipment such as the management server 10 or the terminal apparatus 20 according to the embodiment (or modification).

As illustrated in FIG. 12, the computer 500 includes a CPU 510, a RAM 520, a read only memory (ROM) 530, a hard disk drive (HDD) 540, a communication interface 550, and an input/output interface 560. Each unit of the computer 500 is coupled by a bus 570.

The CPU 510 operates based on a program stored in the ROM 530 or the HDD 540, and controls each unit. For example, the CPU 510 develops a program stored in the ROM 530 or the HDD 540 in the RAM 520, and executes processing corresponding to various programs.

The ROM 530 stores a boot program such as a basic input output system (BIOS) executed by the CPU 510 when the computer 500 is activated, a program that depends on hardware of the computer 500, or the like.

The HDD 540 is a computer-readable recording medium that non-transiently records a program executed by the CPU 510, data used by the program, and the like. Specifically, the HDD 540 is a recording medium that records an information processing program according to the present disclosure as an example of program data 541.

The communication interface 550 is an interface for the computer 500 to couple to an external network 580 (for example, the Internet). For example, the CPU 510 receives data from another equipment or transmits data generated by the CPU 510 to another equipment via the communication interface 550.

The input/output interface 560 is an interface for coupling an input/output device 590 to the computer 500. For example, the CPU 510 receives data from an input device such as a keyboard or a mouse via the input/output interface 560. In addition, the CPU 510 transmits data to an output device such as a display, a speaker, or a printer via the input/output interface 560.

Note that the input/output interface 560 may function as a media interface that reads a program or the like recorded in a predetermined recording medium (medium). As the medium, for example, an optical recording medium such as a digital versatile disc (DVD) or a phase change rewritable disk (PD), a magneto-optical recording medium such as a magneto-optical disk (MO), a tape medium, a magnetic recording medium, a semiconductor memory, or the like is used.

Here, for example, in a case where the computer 500 functions as information equipment such as the management server 10 or the terminal apparatus 20 according to the embodiment (or modification) of the embodiment, the CPU 510 of the computer 500 executes the information processing program loaded on the RAM 520, thereby realizing all or some of the functions of the respective units such as the management server 10 or the terminal apparatus 20 according to the embodiment (or modification) of the embodiment. In addition, the HDD 540 stores an information processing program and data (for example, temperature information, temperature control information, or the like) according to the present disclosure. Note that the CPU 510 reads and executes the program data 541 from the HDD 540, but as another example, these programs may be acquired from another apparatus via the external network 580.

### <4. Appendix>

Note that the present technology can also have the following configurations.
(1) An information processing apparatus comprising:
   a reception unit configured to receive temperature information from an apparatus including a temperature adjustment unit configured to adjust a temperature by cooling or heating;
   a storage unit configured to store log information in which pieces of the temperature information are arranged in time series;
   an acquisition unit configured to obtain a temperature change degree based on the log information;
   a generation unit configured to generate temperature control information for controlling the temperature based on the temperature change degree; and
   a transmission unit configured to transmit the temperature control information to the apparatus.
(2) The information processing apparatus according to (1), wherein
   the reception unit receives software information indicating software being activated of the apparatus and the temperature information of the apparatus,
   the storage unit stores the log information in which the software information and the temperature information of the apparatus are arranged in time series, and
   the acquisition unit obtains the temperature change degree of the apparatus based on the log information.
(3) The information processing apparatus according to (2), wherein
   the acquisition unit obtains a temperature rise rate or a temperature drop rate of the apparatus as the temperature change degree of the apparatus based on the log information.
(4) The information processing apparatus according to (2) or (3), wherein
   when a plurality of pieces of software are being activated in the apparatus, the reception unit receives the software information indicating a plurality of pieces of the software being activated and the temperature information of the apparatus.
(5) The information processing apparatus according to (4), wherein
   the acquisition unit obtains a temperature rise rate or a temperature drop rate of the apparatus corresponding to a combination of the plurality of pieces of software being activated as the temperature change degree of the apparatus based on the log information.
(6) The information processing apparatus according to (4) or (5), wherein
   the acquisition unit selects a plurality of pieces of the software information and the temperature information of a plurality of the apparatuses to be used from the log information, and obtains the temperature change degree of the apparatus based on the selected plurality of pieces of the software information and the temperature information of the plurality of apparatuses.
(7) The information processing apparatus according to (6), wherein
   the acquisition unit selects the plurality of pieces of software information and the temperature information of the plurality of apparatuses to be used from the log information according to a contribution degree by which the software contributes to temperature change of the apparatus.
(8) The information processing apparatus according to (7), wherein
   the acquisition unit obtains the software of which a contribution degree is the highest or higher than a predetermined value based on the log information, and selects the software information corresponding to the obtained software and the temperature information of the apparatus.
(9) The information processing apparatus according to any one of (2) to (8), wherein
   the reception unit periodically receives the software information and the temperature information of the apparatus from the apparatus.
(10) The information processing apparatus according to any one of (2) to (8), wherein
   the reception unit collectively and periodically receives the plurality of pieces of software information and the temperature information of the plurality of apparatuses from the apparatus.
(11) The information processing apparatus according to any one of (2) to (10), wherein
   the log information is data related to battery consumption of the apparatus.
(12) The information processing apparatus according to any one of (2) to (11), wherein
   the temperature information of the apparatus is battery temperature information of the apparatus.
(13) The information processing apparatus according to any one of (2) to (12), wherein
   the temperature control information is information for suppressing temperature change of the apparatus.
(14) The information processing apparatus according to any one of (1) to (13), wherein
   the transmission unit transmits the temperature control information to another apparatus other than the apparatus.
(15) An information processing apparatus comprising:
   a transmission unit configured to obtain a temperature change degree based on log information in which pieces of temperature information are arranged in time series, and transmit the temperature information to an apparatus that generates temperature control information based on the obtained temperature change degree;
   a reception unit configured to receive the temperature control information from the apparatus; and
   a control unit configured to control a temperature adjustment unit configured to adjust a temperature by cooling or heating based on the temperature control information.
(16) The information processing apparatus according to (15), wherein
   the transmission unit transmits software information indicating software being activated of the information processing apparatus and the temperature information of the information processing apparatus.
(17) The information processing apparatus according to (16), wherein
   in a case where a plurality of pieces of software are being activated in the information processing apparatus, the transmission unit transmits the software information indicating the plurality of pieces of software being activated and the temperature information of the information processing apparatus.
(18) The information processing apparatus according to any one of (15) to (17), further comprising:
   a display unit configured to display an image or characters indicating that the control unit controls the temperature adjustment unit.
(19) The information processing apparatus according to any one of (15) to (17), further comprising:
   a display unit configured to display a remaining operable prediction time of the information processing apparatus.
(20) An information processing system comprising:
   an acquisition unit configured to obtain a temperature change degree based on log information in which pieces of temperature information are arranged in time series;
   a generation unit configured to generate temperature control information for controlling a temperature based on the temperature change degree; and
   a control unit configured to control a temperature adjustment unit configured to adjust the temperature by cooling or heating based on the temperature control information.
(21) An information processing system including the information processing apparatus according to any one of (1) to (19).
(22) An information processing method using the information processing apparatus according to any one of (1) to (19).

### Reference Signs List

- 1: INFORMATION PROCESSING SYSTEM
- 10: MANAGEMENT SERVER
- 11: COMMUNICATION UNIT
- 12: STORAGE UNIT
- 13: CONTROL UNIT
- 13a: RECEPTION UNIT
- 13b: STORAGE UNIT
- 13c: ACQUISITION UNIT
- 13d: GENERATION UNIT
- 13e: TRANSMISSION UNIT
- 20: TERMINAL APPARATUS
- 21: MAIN BODY
- 21a: COMMUNICATION UNIT
- 21b: STORAGE UNIT
- 21c: INPUT UNIT
- 21d: OUTPUT UNIT
- 21e: SENSOR UNIT
- 21f: CONTROL UNIT
- 21g: BATTERY
- 22: COVER
- 22a: CONTROL UNIT
- 22b: COOLING/HEATING UNIT
- 22c: BATTERY
- 26: SENSOR UNIT
- 211: MONITORING UNIT
- 212: TRANSMISSION UNIT
- 213: RECEPTION UNIT
- G1: TEMPERATURE CONTROL NOTIFICATION IMAGE
- N: NETWORK

## Claims

1. An information processing apparatus comprising:
a reception unit configured to receive temperature information from an apparatus including a temperature adjustment unit configured to adjust a temperature by cooling or heating;
a storage unit configured to store log information in which pieces of the temperature information are arranged in time series;
an acquisition unit configured to obtain a temperature change degree based on the log information;
a generation unit configured to generate temperature control information for controlling the temperature based on the temperature change degree; and
a transmission unit configured to transmit the temperature control information to the apparatus.

2. The information processing apparatus according to claim 1, wherein
the reception unit receives software information indicating software being activated of the apparatus and the temperature information of the apparatus,
the storage unit stores the log information in which the software information and the temperature information of the apparatus are arranged in time series, and
the acquisition unit obtains the temperature change degree of the apparatus based on the log information.

3. The information processing apparatus according to claim 2, wherein
the acquisition unit obtains a temperature rise rate or a temperature drop rate of the apparatus as the temperature change degree of the apparatus based on the log information.

4. The information processing apparatus according to claim 2, wherein
when a plurality of pieces of software are being activated in the apparatus, the reception unit receives the software information indicating a plurality of pieces of the software being activated and the temperature information of the apparatus.

5. The information processing apparatus according to claim 4, wherein
the acquisition unit obtains a temperature rise rate or a temperature drop rate of the apparatus corresponding to a combination of the plurality of pieces of software being activated as the temperature change degree of the apparatus based on the log information.

6. The information processing apparatus according to claim 4, wherein
the acquisition unit selects a plurality of pieces of the software information and the temperature information of a plurality of the apparatuses to be used from the log information, and obtains the temperature change degree of the apparatus based on the selected plurality of pieces of the software information and the temperature information of the plurality of apparatuses.

7. The information processing apparatus according to claim 6, wherein
the acquisition unit selects the plurality of pieces of software information and the temperature information of the plurality of apparatuses to be used from the log information according to a contribution degree by which the software contributes to temperature change of the apparatus.

8. The information processing apparatus according to claim 7, wherein
the acquisition unit obtains the software of which a contribution degree is the highest or higher than a predetermined value based on the log information, and selects the software information corresponding to the obtained software and the temperature information of the apparatus.

9. The information processing apparatus according to claim 2, wherein
the reception unit periodically receives the software information and the temperature information of the apparatus from the apparatus.

10. The information processing apparatus according to claim 2, wherein
the reception unit collectively and periodically receives the plurality of pieces of software information and the temperature information of the plurality of apparatuses from the apparatus.

11. The information processing apparatus according to claim 2, wherein
the log information is data related to battery consumption of the apparatus.

12. The information processing apparatus according to claim 2, wherein
the temperature information of the apparatus is battery temperature information of the apparatus.

13. The information processing apparatus according to claim 2, wherein
the temperature control information is information for suppressing temperature change of the apparatus.

14. The information processing apparatus according to claim 1, wherein
the transmission unit transmits the temperature control information to another apparatus other than the apparatus.

15. An information processing apparatus comprising:
a transmission unit configured to obtain a temperature change degree based on log information in which pieces of temperature information are arranged in time series, and transmit the temperature information to an apparatus that generates temperature control information based on the obtained temperature change degree;
a reception unit configured to receive the temperature control information from the apparatus; and
a control unit configured to control a temperature adjustment unit configured to adjust a temperature by cooling or heating based on the temperature control information.

16. The information processing apparatus according to claim 15, wherein
the transmission unit transmits software information indicating software being activated of the information processing apparatus and the temperature information of the information processing apparatus.

17. The information processing apparatus according to claim 16, wherein
in a case where a plurality of pieces of software are being activated in the information processing apparatus, the transmission unit transmits the software information indicating the plurality of pieces of software being activated and the temperature information of the information processing apparatus.

18. The information processing apparatus according to claim 15, further comprising:
a display unit configured to display an image or characters indicating that the control unit controls the temperature adjustment unit.

19. The information processing apparatus according to claim 15, further comprising:
a display unit configured to display a remaining operable prediction time of the information processing apparatus.

20. An information processing system comprising:
an acquisition unit configured to obtain a temperature change degree based on log information in which pieces of temperature information are arranged in time series;
a generation unit configured to generate temperature control information for controlling a temperature based on the temperature change degree; and
a control unit configured to control a temperature adjustment unit configured to adjust the temperature by cooling or heating based on the temperature control information.
